# EUROPEAN PATENT APPLICATION

(11) **EP 3 404 833 A1**
(43) Date of publication of application: **21.11.2018**
(21) Application number: 17171478.5
(22) Date of filing: 17.05.2017
(51) Int. Cl.: H03K 7/06

(54) **TRANSMITTER FOR A WIRELESS COMMUNICATION NETWORK, RECEIVER FOR A WIRELESS COMMUNICATION NETWORK, NETWORK NODE FOR A WIRELESS COMMUNICATION NETWORK AND WIRELESS COMMUNICATION NETWORK**

(71) Applicant: Vestel Elektronik Sanayi ve Ticaret A.S., 45030 Manisa (TR); Ozyegin Universitesi, 34794 Istanbul (TR)
(72) Inventor: GÜLBAHAR, Burhan, 34794 Çekmeköy/Istanbul (TR); TÜFEKCI, Burak, 45030 Manisa (TR)
(74) Representative: Ascherl, Andreas

(57) **Abstract**

The present invention provides a network node (107, 108, 109, 110, 111, 112, 113, 114, 207, 208, 209, 210, 211, 212, 213, 214, 307, 308, 309, 310, 311, 312, 313, 314, 407) for a wireless communication network (100, 200, 300) with at least one transmitter (101, 201, 301) and at least one receiver (115, 215, 315), comprising a receiving antenna (430) configured to receive an incoming wireless signal (431), an emitting antenna configured to emit an outgoing wireless signal (150, 444), and a control unit (443) configured to generate the outgoing wireless signal (150, 444) and provide the outgoing wireless signal (150, 444) to the emitting antenna, wherein the frequency of the outgoing wireless signal (150, 444) is predetermined based on the frequency of the incoming wireless signal (431). Further, the present invention provides a respective wireless communication network (100, 200, 300), a respective transmitter (101, 201, 301) and a respective receiver (115, 215, 315).

## Description

### TECHNICAL FIELD

The invention relates to a transmitter for a wireless communication network, a receiver for a wireless communication network, a network node for a wireless communication network and a wireless communication network.

### BACKGROUND

Although applicable to any system that transmits data, the present invention will mainly be described in conjunction with wireless data communication systems.

In modern technology data needs to be effectively transmitted between a plurality of nodes. Exemplary applications may e.g. be automations systems, sensor networks, building control systems or the like.

Since it is not always possible to provide respective cabling, the use of wireless data networks suggests itself. In wireless data networks the single nodes are usually provided with an energy source that allows autonomous operation of the respective node. The energy source may e.g. be a local mains adapter or a battery or the like.

The single nodes in wireless networks usually transmit and receive data according to predetermined communication protocols. Therefore, in every node the used communication protocol needs to be known and a unit that is capable of decoding and encoding data according to the respective communication protocol is required.

Such a unit requires electrical energy and therefore reduces the energy efficiency of the data transmission system. A reduced operational life for e.g. battery powered nodes will be the result.

Accordingly, there is a need for more power efficient wireless communication networks.

### SUMMARY OF THE INVENTION

The present invention provides a transmitter with the features of claim 1, a receiver with the features of claim 2, a network node with the features of claim 3 and a wireless communication network with the features of claim 12.

Accordingly it is provided:
A transmitter for a wireless communication network with a plurality of network nodes and at least one receiver, comprising a frequency determination unit that is configured to determine a frequency for an outgoing signal based on data to be transmitted, and an output stage configured to transmit the outgoing signal as unmodulated signal, i.e. without amplitude or phase modulations according to the data to be transmitted, with the determined frequency to a first one of the network nodes for further transmission through the wireless communication network.

Further, it is provided:
- A receiver for a wireless communication network with at least one transmitter and a plurality of network nodes, comprising an input stage configured to receive an incoming wireless signal, a frequency determination unit configured to determine a frequency of the incoming wireless signal, and a mapping unit configured to map the determined frequency to data to be transmitted.

Further, it is provided:
- A network node for a wireless communication network with at least one transmitter and at least one receiver, comprising a receiving antenna configured to receive an incoming wireless signal, an emitting antenna configured to emit an outgoing wireless signal, and a control unit configured to generate the outgoing wireless signal and provide the outgoing wireless signal to the emitting antenna, wherein the frequency of the outgoing wireless signal is predetermined based on the frequency of the incoming wireless signal.

Finally, it is provided:
- A wireless communication network comprising at least one transmitter according to the present invention, at least one receiver according to the present invention, and a plurality of network nodes according to the present invention.

The present invention in contrast to the above mentioned protocol-based wireless networks provides a hardware protocol-less communication system. In a communication system according to the present invention the data content of a data transmission is instead determined by the path that the transmission travels through the communication system.

The transmitter according to the present invention as well as the single network nodes and the receiver according to the present invention all have information about a predetermined common set of transmission frequencies.

The set of transmission frequencies determines frequencies for incoming wireless signals and respective frequencies for outgoing wireless signals for nodes in the communication system. A network node that receives an incoming signal with a first frequency will therefore provide an outgoing signal with the second frequency that is defined in the set of transmission frequencies. That transmission with the second frequency will then be received by a receiver or by another network node that will then determine a third frequency based on the second frequency and so on until the signal reaches a receiver.

A transmitter that wants to send data to a receiver must therefore determine the route that the data will take through the network by selecting a start frequency for the first transmission to the first receiving network node. Based on the frequency of this first transmission the first receiving network node will then select a frequency for the second transmission, and so on until the transmission reaches the receiver.

The frequency determination unit of the transmitter may perform a data-to-frequency conversion. The data-to-frequency mapping used by the frequency determination unit may be predetermined e.g. by the developer of the wireless communication network or during installation or setup of the wireless communication network. The data-to-frequency mapping may especially be determined when it is known how many network nodes and therefore hops between transmitter and receiver the network will comprise.

As indicated above, the transmitter will perform no data specific modulation of the outgoing signal. Instead the data will be encoded in the path that the signal takes from the transmitter to the receiver. It is however understood, that instead of providing e.g. a sine-wave signal, the output stage may provide the signal with the respective frequency in any shape that may be adequate in the wireless communication network. If for example a square-wave signal allows improved energy harvesting in the network nodes, such a square-wave signal may be used.

The frequency determination unit may e.g. be provided as a digital device like a controller or processor with a respective firmware or software. The frequency determination unit may further comprise an output port that allows the frequency determination unit to output the outgoing signal with the determined frequency to the output stage. As an alternative the frequency determination unit may comprise a digital interface to the output stage and provide commands comprising the frequency to the output stage. The output stage may e.g., comprise configurable oscillators like e.g. VCOs (voltage controller oscillators), filters, amplifiers, attenuators or any other element necessary to generate the outgoing signal. Further, the output stage may comprise an antenna for transmitting the outgoing signal.

For example a look-up table may be provided in the transmitter that directly maps a digital data token to a path through the wireless communication network and therefore a frequency for the outgoing signal.

The receiver for the wireless communication network may receive the incoming wireless signal originating from a transmitter via one of the network nodes with a specific frequency. The frequency of the incoming signal at the receiver is determined by the path that the signal takes through the wireless communication network.

Every node on the signal path will determine the frequency of its outgoing signal based on a predetermined mapping based on the frequency of its incoming signal. Therefore, by determining the frequency of the incoming signal the receiver, i.e. the mapping unit is able to look up the data that was transmitted by the transmitter via the wireless communication network.

For example a look-up table may be provided in the receiver that directly maps a frequency to a digital data token.

Since no modulation is performed for transmitting data via the network communication system, the single signals may be very narrow regarding the frequency. This also means that a plurality of different frequencies may be used within a single frequency band. The minimum distance in the frequency domain that is required between the single signals is only limited by the frequency selectivity of the receiving elements in the network nodes and the receivers.

As can be seen with the communication system according to the present invention it is not necessary to use a complex communication protocol on the hardware-level and no decoding on the receiving end is necessary. It is understood however that a software layer communication protocol may e.g. implement error correction mechanisms and the like on top of the data transmission provided by the communication system according to the present invention.

Further embodiments of the present invention are subject of the further subclaims and of the following description, referring to the drawings.

In an embodiment, the network node may comprise an energy harvesting unit configured to harvest electrical energy from the received incoming wireless signal and supply the harvested electrical energy to the control unit.

The network node may be provided where no electrical energy supply is available. The energy harvesting unit may therefore serve to power the control unit when the incoming wireless signal is received. Since in the present invention no electrical energy is wasted for any protocol processing, the network nodes of the present invention may be operated under reduced energy consumption. Therefore, the energy transmitted in the received incoming signal may mainly be used for the transmission of the ongoing or outgoing wireless signal at the respective frequency.

The control unit may e.g. determine if enough energy is harvested to transmit an outgoing signal with the respective frequency to a further node or the receiver. If enough energy is harvested, the control unit may proceed to transmit the outgoing signal. If not enough energy is harvested, the control unit may wait for the incoming signal to provide enough energy for the transmission of the outgoing signal.

The transmitter of the communication system according to the present invention may e.g. repeatedly send the signal to the first network node until the first network node has harvested enough energy.

The transmitter and the receiver may further implement a kind of acknowledgment process that allows the receiver to indicate to the transmitter that a signal was received. The transmitter and the receiver may e.g. both be able to transmit and receive signals via the communication system. The acknowledgment process may e.g. comprise the transmitter transmitting a signal in regular intervals. The nodes on the path to the transmitter will then harvest energy in every one of those regular intervals until every single node on the path is provided with enough energy to transmit the respective outgoing signal. The receiver may then use the same transmission scheme to signal back to the transmitter that the signal was received.

The transmitter and the receiver may further implement a calibration procedure. This calibration procedure may e.g. be performed when a communication system is installed. The calibration procedure may serve the transmitter and the receiver to determine the amount of energy and therefore the required duration for the signal transmission from the transmitter to the first node that will suffice to provide enough electrical energy to all nodes in the signal path. The transmitter may e.g. use the above mentioned acknowledgment process with a first signal transmission and measure the number of signal intervals or the duration of a single signal that where necessary to transmit a signal to the receiver. After performing this calibration the transmitter may then always provide the determined amount of electrical energy to the first node that will suffice to send the signal through all nodes of the signal path to the receiver. The "determined amount of energy" may be provided by transmitting a single signal with the required amount of energy or by transmitting a plurality of consecutive burst signals. It is understood that the "determined amount of energy" may also comprise a safety margin.

In an embodiment, the network node may comprise an impedance matching circuit arranged between the receiving antenna and the energy harvesting unit.

The impedance matching circuit may be tuned according to a specific frequency band, e.g. the frequency band used by the wireless communication network. One network node may therefore harvest energy from signals at different frequencies that are used in the wireless communication network.

In an embodiment, the energy harvesting unit may comprise a rectifier arrangement and an energy storage device configured to supply the control unit with electrical energy.

The rectifier makes sure that only a one way energy flow is allowed in the network node. The energy storage may accumulate electrical energy. This allows the network node to store electrical energy that is received via the wireless incoming signal until enough electrical energy is harvested to perform a signal transmission of its own.

In another embodiment, the control unit may comprise a frequency generator configured to generate for every frequency of the incoming wireless signal the outgoing wireless signal with a predetermined frequency.

The frequency generator may e.g. be an analog or digital component that is capable of generating the outgoing signal based on the incoming signal. The frequency generator may e.g. comprise oscillators, PLLs (phase locked loops) or the like that are driven by the incoming signal. A specific outgoing signal may e.g. be generated by adding specific frequency signals to the incoming signal. The frequency signals may comprise a frequency that represents the difference between the frequency of the incoming signal and the frequency of the outgoing signal. Therefore the outgoing signal may be generated by adding the incoming signal and the respective frequency signal.

In an embodiment, the frequency generator may comprise a controller coupled to the receiving antenna and the emitting antenna and configured to measure the frequency of the incoming wireless signal and to generate the outgoing wireless signal with the respective frequency.

A controller allows easily creating signals with different frequencies as required in the wireless communication network. The controller may further implement additional functionality in a firmware or operating software that e.g. allows performing over the air updates of the frequency mapping and the like. Therefore, with a controller as frequency generator the network nodes may be implemented with great flexibility.

The controller may e.g. be a low power/low energy consumption microcontroller that comprises e.g. capture-compare enabled inputs for measuring a frequency and for generating the outgoing signal with a predetermined frequency.

The controller may further be coupled to oscillators, e.g. VCOs, that are designed to generate signals in the required frequency range, e.g. in the millimeter wave frequency range of 30GHz to 300GHz.

In a further embodiment, the frequency generator may comprise a look-up table comprising for every possible frequency of the incoming signal the respective frequency for the outgoing signal.

A look-up table is a very simple and effective way of mapping a frequency of an incoming signal to the frequency of an outgoing signal. Especially in combination with a controller the look-up table may e.g. be easily updated.

In an embodiment, the control unit may be configured to ignore incoming signals with predefined frequencies to be ignored.

A network node may e.g. be one node in a group of network nodes that is provided as a specific hop or stage in the network path from a transmitter to a receiver. For example two network nodes may be provided at a first hop/stage and another two network nodes may be provided in a second hop/stage.

The first hop/stage may therefore represent the first bit and the second hop/stage may represent the second bit of a two-bit value, e.g. decimal values from 0 to 3. If a signal is e.g. transmitted from the transmitter to the first stage/hop at a first frequency that e.g. represents a binary 01, it may be intended that only the first network node of the first hop/stage forwards a signal to the second network node of the second hop/stage. Therefore, the second node of the first hop/stage must ignore the signal with the first frequency.

The first network node of the first hop/stage will then transmit a signal to the second hop/stage that indicates to the second network node of the second hop/stage that it should transmit a signal to the receiver. The last network node in the signal path may select the frequency for the outgoing signal according to the network node that sent the signal to that last network node, i.e. according to the frequency of the incoming signal.

In another embodiment, the emitting antenna may comprise an antenna with a predefined directivity.

Providing an antenna with a high directivity allows using different network nodes or groups of network nodes in the same area. The emitting antennas of the single network nodes may e.g. be focused only onto the network node or group of network nodes that form the next hop in the signal path of the communication system.

It is understood that as an alternative the emitting antenna and the receiving antenna may be a single or the same antenna. The single groups of nodes or network nodes may be differentiated by the frequencies they use.

In an embodiment, the network nodes may be arranged in first network node groups and one first network node group may be provided for every hop in a signal path from the at least one transmitter to the at least one receiver.

The number of network node groups and the number of nodes in each network node group define the number of possible paths that a signal may take when traveling through the wireless communication network from a transmitter to a receiver.

The data word that may be transmitted in the wireless communication network with a single signal transmission from the transmitter to the receiver is therefore determined by the number of network nodes in each network node group and the number of network node groups.

If for example two groups with four network nodes each are provided, 2⁴=16 paths exist and therefore a single signal transmission may represent a value between 0 and 15.

In a further embodiment, the network nodes may be arranged in second network node groups and one second network node group may be provided for every hop in a signal path from the at least one receiver to the at least one transmitter.

The wireless communication network may provide a return path for signals from the transmitter to the receiver.

The first network node groups may e.g. be separated from the second network node groups by using different frequencies. Alternatively, the first network node groups may e.g. be separated from the second network node groups spatially, e.g. by orienting the antennas of the single nodes to different directions.

### BRIEF DESCRIPTION OF THE DRAWINGS

For a more complete understanding of the present invention and advantages thereof, reference is now made to the following description taken in conjunction with the accompanying drawings. The invention is explained in more detail below using exemplary embodiments which are specified in the schematic figures of the drawings, in which:
Fig. 1 shows a block diagram of an embodiment of a wireless communication network according to the present invention;
Fig. 2 shows a block diagram of an embodiment of a wireless communication network according to the present invention;
Fig. 3 shows a block diagram of an embodiment of a wireless communication network according to the present invention;
Fig. 4 shows a block diagram of an embodiment of a network node according to the present invention; and
Fig. 5 shows a flow diagram of a method that may be executed for transmitting data in a wireless communication network according to the present invention.

In the figures like reference signs denote like elements unless stated otherwise.

### DETAILED DESCRIPTION OF THE DRAWINGS

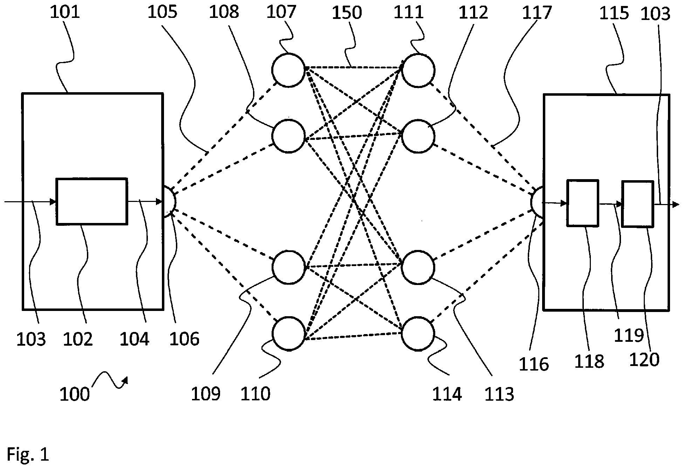

Fig. 1 shows a block diagram of an embodiment of a wireless communication network 100. The wireless communication network 100 comprises a transmitter 101 and a receiver 115. Between the transmitter 101 and the receiver 115 a plurality of network nodes 107, 108, 109, 110, 111, 112, 113, 114 are provided. Although eight network nodes are shown in the wireless communication network 100, it is understood that any number of network nodes may be used. As was already explained above, the number of network nodes 107, 108, 109, 110, 111, 112, 113, 114 determines the number of bits that may be transported with a single communication transmission through the wireless communication network 100. In the present example 2 groups with 4 nodes each allow transporting 4² bits with a single data transmission.

The transmitter 101 receives data 103 that has to be transmitted to the receiver 115. A frequency determination unit 102 determines a frequency 104 for an outgoing signal 105. The data 103 may e.g. already be segmented into data chunks that have the same bit-length as the number of bits that may be transported through the wireless communication network 100 with a single transmission. Alternatively, the frequency determination unit 102 may receive a continuous data stream and perform the segmentation locally. The frequency determination unit 102 may e.g. comprise a look-up table that maps a bit-value to a respective frequency 104. The output stage 106 will then emit or transmit a signal with the selected frequency 104. The signal may e.g. be a pure sine wave signal or a square wave signal or the like. Therefore in the output stage 106 no complex encoders are necessary. Instead e.g. simple VCOs (voltage controlled oscillators) may be used to generate the signal with the respective frequency.

The outgoing signal 105 is then transmitted to the network nodes 107, 108, 109, 110. The network nodes 107, 108, 109, 110, 111, 112, 113, 114 are arranged in two groups. The first group comprises the network nodes 107, 108, 109, 110 and the second group comprises the network nodes 111, 112, 113, 114. The first group of network nodes 107, 108, 109, 110 will always receive the outgoing signal 105 from the transmitter 101. The first group of network nodes 107, 108, 109, 110 will then forward an intermediate signal 150 to the second group of network nodes 111, 112, 113, 114. It is understood that only a single one of the first group of network nodes 107, 108, 109, 110 will forward the outgoing signal 105 as intermediate signal 150. When sending the intermediate signal 150 the respective node may use a specific frequency for the intermediate signal 150 that is predetermined. The same applies to the nodes of the second group of network nodes 111, 112, 113, 114, as will be described in detail below.

Finally, the second group of network nodes 111, 112, 113, 114 will forward an incoming wireless signal 117 to the receiver 115. The receiver 115 comprises an input stage 116, e.g. with a receiving antenna and respective analog filters, amplifies or attenuators as required. The input stage 116 forwards the incoming wireless signal 117 to a frequency determination unit 118 that determines the frequency 119 of the incoming wireless signal 117. Based on the frequency 119 a mapping unit 120 maps the frequency 119 to the data 103. The mapping unit 120 therefore performs the reverse operation as the frequency determination unit 102. At the end the data 103 is reconstructed in the receiver and may be combined with other received data to form a data stream.

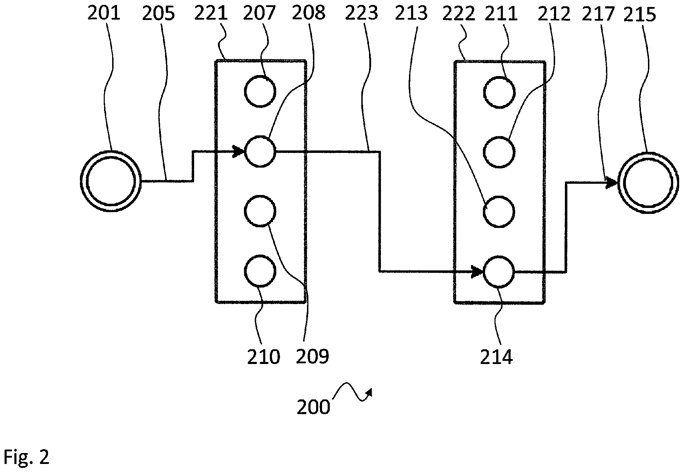

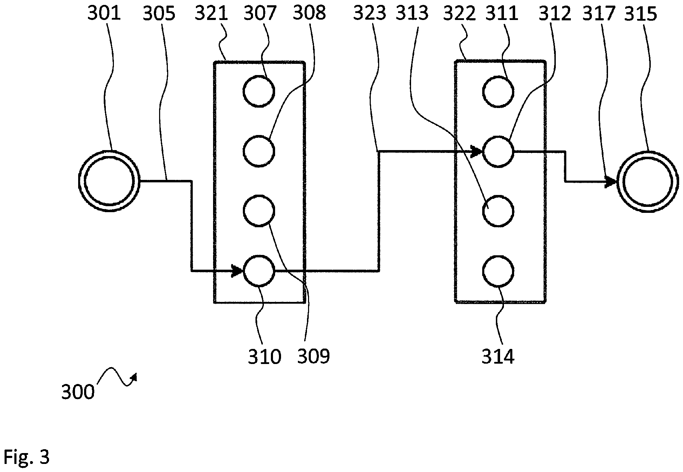

The data transmission through the wireless communication network 100 and the scheme of encoding the data 103 in the path that the outgoing signal 105 travels via the network nodes 107, 108, 109, 110, 111, 112, 113, 114 will be explained below in conjunction with Figs. 2 and 3.

Fig. 2 shows a block diagram of an embodiment of a wireless communication network 200. The wireless communication network 200 comprises a transmitter 201, a first group 221 of network nodes 207, 208, 209, 210 and a second group 222 of network nodes 211, 212, 213, 214 and a receiver 215.

In the wireless communication network 200 every group of network nodes provides 4 different inputs, i.e. the respective network nodes 207, 208, 209, 210 and network nodes 211, 212, 213, 214. The outgoing signal 205 travels from the transmitter 201 via one of the network nodes 207, 208, 209, 210 of the first group 221 and then one of the network nodes 211, 212, 213, 214 of the second group 222 to the receiver 215. Therefore, a signal may travel via 4*4 different paths from the transmitter 201 to the receiver 215. The receiver 215 will know from the frequency of the incoming wireless signal 217 which path the incoming wireless signal 217 travelled and may therefore determine the data content of the incoming wireless signal 217.

In Fig. 2 an exemplary path of an outgoing signal 205 is shown. The outgoing signal 205 is transmitted from the transmitter 201 to the first group 221. The frequency of the outgoing signal 205 determines, which of the network nodes 207, 208, 209, 210 accepts and forwards the signal. Further, the frequency of the outgoing signal 205 determines to which one of the network nodes 211, 212, 213, 214 of the second group 222 the intermediate signal 223 is forwarded and with which frequency.

Therefore, in the wireless communication network 200 there may be provided 16 different frequencies for the outgoing signal 205. Four frequencies that are received by node 207, four frequencies that are received by node 208, four frequencies that are received by node 209 and four frequencies that are received by node 210. As an alternative the network nodes 207, 208, 209, 210 may be placed such that the outgoing signal 105 may be sent with a directionality from the transmitter 201 that allows only one single network node 207, 208, 209, 210 to receive the outgoing signal 205. In that case four frequencies for the outgoing signal 205 would suffice to indicate to the network nodes 207, 208, 209, 210 to which one of the network nodes 211, 212, 213, 214 the intermediate signal 223 should be forwarded.

For the signal transmission from the network nodes 207, 208, 209, 210 to the network nodes 211, 212, 213, 214 there may also be provided 16 different frequencies. Four that indicate the receiving network node 211, 212, 213, 214 when the intermediate signal 223 is sent from the network node 207, four that indicate the receiving network node 211, 212, 213, 214 when the intermediate signal 223 is sent from the network node 208, four that indicate the receiving network node 211, 212, 213, 214 when the intermediate signal 223 is sent from the network node 209 and four that indicate the receiving network node 211, 212, 213, 214 when the intermediate signal 223 is sent from the network node 210.

The frequencies for the intermediate signal 223 may be the same as the frequencies for the outgoing signal 205, if the signal paths do not overlap. If the signal paths of the intermediate signal 223 and the outgoing signal 205 overlap, different frequencies may be used.

Finally, 16 frequencies may be provided to indicate to the receiver 215 from which network nodes 207, 208, 209, 210 the intermediate signal 223 was received and by which network nodes 211, 212, 213, 214 the incoming wireless signal 217 was provided. Again, the frequencies for the intermediate signal 223 may be the same as the frequencies for the incoming wireless signal 217, if the respective signal paths do not overlap. If the signal paths of the intermediate signal 223 and the incoming wireless signal 217 overlap, different frequencies may be used.

The outgoing signal 205 in Fig. 2 is transmitted via the 8^{th} possible path to the receiver 215. The first possible path would be the path via network node 207 and network node 211, and the last possible path would be the path via network node 210 and network node 214.

The outgoing signal 205 in Fig. 2 is provided from the transmitter 201 to the network node 208, from the network node 208 to the network node 214 and from the network node 214 to the receiver 215. The incoming wireless signal 217 may e.g. have the 8^{th} possible frequency that indicates to the receiver 215 that the 8^{th} possible path was travelled by the incoming wireless signal 217. Since values from 0 - 15 may be transmitted via the wireless communication network 200, the 8^{th} possible path may indicate a value of 7 or a binary value of 0111.

Fig. 3 shows a block diagram of an embodiment of a wireless communication network 300. The wireless communication network 300 is based on the wireless communication network 200 and comprises a transmitter 301, a first group 321 of network nodes 307, 308, 309, 310 and a second group 322 of network nodes 311, 312, 313, 314 and a receiver 315. The structure of the wireless communication network 300 is the same as for the wireless communication network 200 and the above explanations regarding the possible signal paths and frequencies also apply to the wireless communication network 300.

In the wireless communication network 300 the outgoing signal 305 travels another path than the outgoing signal 205. The outgoing signal 305 is provided from the transmitter 301 to the fourth network node 310 of the first group 321. From the fourth network node 310 of the first group 321 the signal is provided to the second network node 312 of the second group 322. Therefore, the outgoing signal 305 travels the 14^{th} possible path through the wireless communication network 300 until it arrives as incoming wireless signal 317 at the receiver 315.

The incoming wireless signal 317 may e.g. have the 14^{th} possible frequency for signals from the network nodes 311, 312, 313, 314 to the receiver 315. Since values from 0 - 15 may be transmitted via the wireless communication network 300, the 14^{th} possible path may indicate a value of 13 or a binary value of 1011.

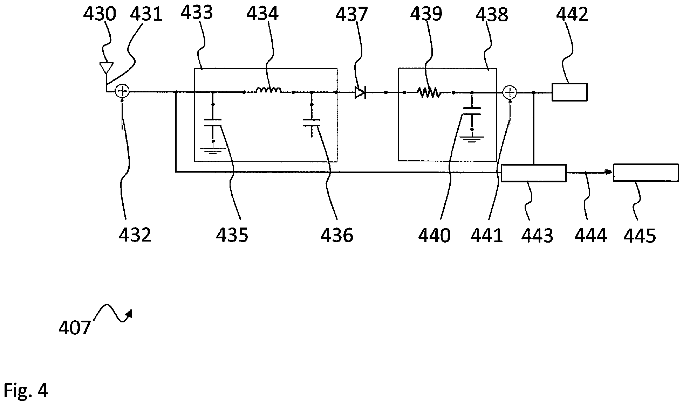

Fig. 4 shows a block diagram of an embodiment of a network node 407. The network node 407 comprises a receiving antenna 430 for receiving the incoming wireless signal 431. The incoming wireless signal 431 may comprise or be mixed with additive noise 432 that may be added by the communication channel, shown in Fig. 4 as signal 432 that is added to the incoming wireless signal 431. In the present invention the noise may be used in a positive way. Since no decoding is necessary and only single frequency signals are transmitted, the noise may be advantageously used in the energy harvesting section of the network node 407, as will be explained below.

The incoming wireless signal 431 is forwarded to a control unit or controller 443 that determines the frequency of the incoming wireless signal 431 and provides a respective outgoing signal 444 with a respective frequency to an output 445 of the network node 407.

The energy harvesting section (not separately referenced) of the network node 407 comprises an impedance matching circuit 433 with a capacitor 435 connected to ground, an inductance 434 in the signal line and another capacitor 436 connected to ground. The signal is then passed through diode 437 and a low pass filter 438. The low pass filter 438 comprises a resistance in the signal line and a capacitor 440 to ground. Further noise may be added to the signal from the rectifier (shown as noise signal 441). The output of the low pass filter 438 is then provided to the energy storage 442, e.g. a battery or capacitor like a so called super-cap or gold-cap.

The low pass filter 438 directly and/or the energy storage 442 may provide the controller 443 with electrical energy. The controller 443 may also be configured to measure the amount of electrical energy available in the energy storage 442, e.g. via a voltage measurement. The controller 443 may then decide based on the amount of available energy whether to emit the outgoing signal 444 or wait for more energy to be harvested.

The controller 443 may e.g. comprise a digital controller. It is however understood that the controller 443 may comprise in addition or as alternative any type and number of analog elements, like e.g. filters, oscillators or the like that are necessary to generate a predetermined output frequency from another predetermined input frequency.

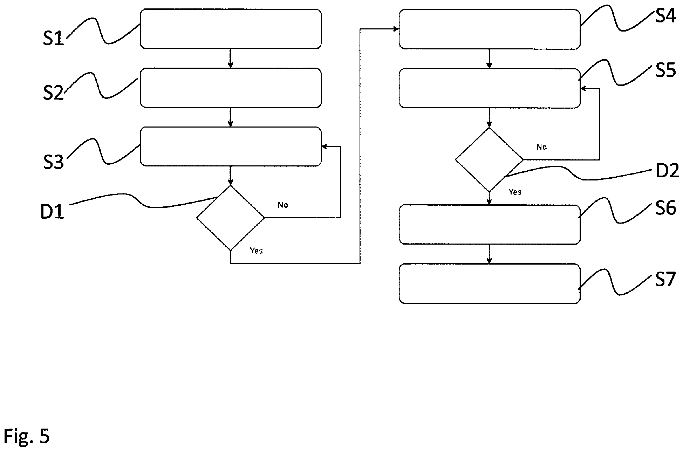

In the following description of the method based Fig. 5 for sake of clarity the reference signs used above in the description of apparatus based Figs. 1 - 4 will be used.

Fig. 5 shows a flow diagram of a method that may be executed by a transmitter 101, 201, 301 and network nodes 107, 108, 109, 110, 111, 112, 113, 114, 207, 208, 209, 210, 211, 212, 213, 214, 307, 308, 309, 310, 311, 312, 313, 314, 407 for transmitting data in a wireless communication network 100, 200, 300.

The transmitter 101, 201, 301 at step S1 determines based on the data 103 to be transmitted the path of the signal through the wireless communication network 100, 200, 300, and therefore the frequency for the outgoing signal 105, 205, 305.

The transmitter 101, 201, 301 then transmits in step S2 the outgoing signal 105, 205, 305 to the first group 221, 321 of network nodes 107, 108, 109, 110, 111, 112, 113, 114, 207, 208, 209, 210, 211, 212, 213, 214, 307, 308, 309, 310, 311, 312, 313, 314, 407 or only the respective network node 107, 108, 109, 110, 111, 112, 113, 114, 207, 208, 209, 210, 211, 212,213,214,307,308,309,310,311,312,313,314,407.

The respective network node 107, 108, 109, 110, 111, 112, 113, 114, 207, 208, 209, 210, 211, 212, 213, 214, 307, 308, 309, 310, 311, 312, 313, 314, 407 will know from the frequency of the outgoing signal 105, 205, 305 that it has to forward the signal with a specific frequency either to the receiver or another network node 107, 108, 109, 110, 111, 112, 113, 114, 207, 208, 209, 210, 211, 212, 213, 214, 307, 308, 309, 310, 311, 312, 313, 314, 407.

Therefore, the respective network node 107, 108, 109, 110, 111, 112, 113, 114, 207, 208, 209, 210, 211, 212, 213, 214, 307, 308, 309, 310, 311, 312, 313, 314, 407 will harvest electrical energy in step S3 from the received outgoing signal 105, 205, 305. In decision D1 the network node 107, 108, 109, 110, 111, 112, 113, 114, 207, 208, 209, 210, 211, 212, 213, 214, 307, 308, 309, 310, 311, 312, 313, 314, 407 decides whether enough energy was harvested or not. If enough energy was harvested the network node 107, 108, 109, 110, 111, 112, 113, 114, 207, 208, 209, 210, 211, 212, 213, 214, 307, 308, 309, 310, 311, 312, 313, 314, 407 transmits in step S4 an intermediate signal 150, 223, 323 either to the receiver 115, 215, 315 or to another network node 107, 108, 109, 110, 111, 112, 113, 114, 207, 208, 209, 210, 211, 212, 213, 214, 307, 308, 309, 310, 311, 312, 313, 314, 407.

This second network node 107, 108, 109, 110, 111, 112, 113, 114, 207, 208, 209, 210, 211, 212, 213, 214, 307, 308, 309, 310, 311, 312, 313, 314, 407 will again harvest electrical energy in step S5 and decide in decision D2 if enough electrical energy was harvested. After harvesting enough electrical energy in step S6 the second network node 107, 108, 109, 110, 111, 112, 113, 114, 207, 208, 209, 210, 211, 212, 213, 214, 307, 308, 309, 310, 311, 312, 313, 314, 407 transmits a signal with a specific frequency to the receiver 115, 215, 315.

The receiver 115, 215, 315 will then determine the content of the signal as already described above based on the frequency of the incoming wireless signal 117, 217, 317.

Although specific embodiments have been illustrated and described herein, it will be appreciated by those of ordinary skill in the art that a variety of alternate and/or equivalent implementations exist. It should be appreciated that the exemplary embodiment or exemplary embodiments are only examples, and are not intended to limit the scope, applicability, or configuration in any way. Rather, the foregoing summary and detailed description will provide those skilled in the art with a convenient road map for implementing at least one exemplary embodiment, it being understood that various changes may be made in the function and arrangement of elements described in an exemplary embodiment without departing from the scope as set forth in the appended claims and their legal equivalents. Generally, this application is intended to cover any adaptations or variations of the specific embodiments discussed herein.

Thus, the present invention provides a network node 107, 108, 109, 110, 111, 112, 113, 114, 207, 208, 209, 210, 211, 212, 213, 214, 307, 308, 309, 310, 311, 312, 313, 314, 407 for a wireless communication network 100, 200, 300 with at least one transmitter 101, 201, 301 and at least one receiver 115, 215, 315, comprising a receiving antenna 430 configured to receive an incoming wireless signal 431, an emitting antenna configured to emit an outgoing wireless signal 150, 444, and a control unit 443 configured to generate the outgoing wireless signal 150, 444 and provide the outgoing wireless signal 150, 444 to the emitting antenna, wherein the frequency of the outgoing wireless signal 150, 444 is predetermined based on the frequency of the incoming wireless signal 431. Further, the present invention provides a respective wireless communication network 100, 200, 300, a respective transmitter 101, 201, 301 and a respective receiver 115, 215, 315.

### List of reference signs

- 100, 200, 300: wireless communication network
- 101, 201, 301: transmitter
- 102: frequency determination unit
- 103: data
- 104: frequency
- 105, 205, 305: outgoing signal
- 106: output stage
- 107, 108, 109, 110, 111, 112, 113, 114: network node
- 207, 208, 209, 210, 211, 212, 213, 214: network node
- 307, 308, 309, 310, 311, 312, 313, 314: network node
- 407: network node
- 115, 215, 315: receiver
- 116: input stage
- 117, 217, 317: incoming wireless signal
- 118: frequency determination unit
- 119: frequency
- 120: mapping unit
- 150: outgoing wireless signal

- 221, 222, 321, 322: group
- 223, 323: intermediate signal

- 430: receiving antenna
- 431: incoming wireless signal
- 432: noise
- 433: impedance matching circuit
- 434: inductance
- 435, 436: capacitor
- 437: diode
- 438: low pass filter
- 439: resistor
- 440: capacitor
- 441: noise
- 442: energy storage
- 443: controller
- 444: outgoing signal
- 445: output

- S1 - S7: method step
- D1, D2: decision

## Claims

1. Transmitter (101, 201, 301) for a wireless communication network (100, 200, 300) with a plurality of network nodes (107, 108, 109, 110, 111, 112, 113, 114, 207, 208, 209, 210, 211, 212, 213, 214, 307, 308, 309, 310, 311, 312, 313, 314, 407) and at least one receiver (115, 215, 315), comprising
a frequency determination unit (102) that is configured to determine a frequency for an outgoing signal (105, 205, 305) based on data to be transmitted, and
an output stage (106) configured to transmit the outgoing signal (105, 205, 305) as unmodulated signal with the determined frequency to a first one of the network nodes (107, 108, 109, 110, 111, 112, 113, 114, 207, 208, 209, 210, 211, 212, 213, 214, 307, 308, 309, 310, 311, 312, 313, 314, 407) for further transmission through the wireless communication network (100, 200, 300).

2. Receiver (115, 215, 315) for a wireless communication network (100, 200, 300) with at least one transmitter (101, 201, 301) and a plurality of network nodes (107, 108, 109, 110, 111, 112, 113, 114, 207, 208, 209, 210, 211, 212, 213, 214, 307, 308, 309, 310, 311, 312, 313, 314, 407), comprising
an input stage (116) configured to receive an incoming wireless signal (117, 217, 317, 431),
a frequency determination unit (118) configured to determine a frequency (119) of the incoming wireless signal (117, 217, 317, 431), and
a mapping unit (120) configured to map the determined frequency (119) to data to be transmitted.

3. Network node (107, 108, 109, 110, 111, 112, 113, 114, 207, 208, 209, 210, 211, 212, 213, 214, 307, 308, 309, 310, 311, 312, 313, 314, 407) for a wireless communication network (100, 200, 300) with at least one transmitter (101, 201, 301) and at least one receiver (115, 215, 315), comprising:
a receiving antenna (430) configured to receive an incoming wireless signal (431),
an emitting antenna configured to emit an outgoing wireless signal (150, 444), and
a control unit (443) configured to generate the outgoing wireless signal (150, 444) and provide the outgoing wireless signal (150, 444) to the emitting antenna, wherein the frequency of the outgoing wireless signal (150, 444) is predetermined based on the frequency of the incoming wireless signal (431).

4. Network node (107, 108, 109, 110, 111, 112, 113, 114, 207, 208, 209, 210, 211, 212, 213, 214, 307, 308, 309, 310, 311, 312, 313, 314, 407) according to claim 3, comprising an energy harvesting unit configured to harvest electrical energy from the received incoming wireless signal (431) and supply the harvested electrical energy to the control unit (443).

5. Network node (107, 108, 109, 110, 111, 112, 113, 114, 207, 208, 209, 210, 211, 212, 213, 214, 307, 308, 309, 310, 311, 312, 313, 314, 407) according to claim 4, comprising an impedance matching circuit (433) arranged between the receiving antenna (430) and the energy harvesting unit.

6. Network node (107, 108, 109, 110, 111, 112, 113, 114, 207, 208, 209, 210, 211, 212, 213, 214, 307, 308, 309, 310, 311, 312, 313, 314, 407) according to any one of the preceding claims 4 and 5, wherein the energy harvesting unit comprises a rectifier arrangement (437) and an energy storage device (442) configured to supply the control unit (443) with electrical energy.

7. Network node (107, 108, 109, 110, 111, 112, 113, 114, 207, 208, 209, 210, 211, 212, 213, 214, 307, 308, 309, 310, 311, 312, 313, 314, 407) according to any one of the preceding claims 3 to 6, wherein control unit (443) comprises a frequency generator configured to generate for every frequency of the incoming wireless signal (431) the outgoing wireless signal (150, 444) with a predetermined frequency.

8. Network node (107, 108, 109, 110, 111, 112, 113, 114, 207, 208, 209, 210, 211, 212, 213, 214, 307, 308, 309, 310, 311, 312, 313, 314, 407) according to claim 7, wherein the frequency generator comprises a controller coupled to the receiving antenna (430) and the emitting antenna and configured to measure the frequency of the incoming wireless signal (431) and to generate the outgoing wireless signal (150, 444) with the respective frequency.

9. Network node (107, 108, 109, 110, 111, 112, 113, 114, 207, 208, 209, 210, 211, 212, 213, 214, 307, 308, 309, 310, 311, 312, 313, 314, 407) according to any one of claims 7 and 8, wherein the frequency generator comprises a look-up table comprising for every possible frequency of the incoming signal the respective frequency for the outgoing wireless signal (150,444).

10. Network node (107, 108, 109, 110, 111, 112, 113, 114, 207, 208, 209, 210, 211, 212, 213, 214, 307, 308, 309, 310, 311, 312, 313, 314, 407) according to any one of claims 3 to 9, wherein the control unit (443) is configured to ignore incoming signals with predefined frequencies to be ignored.

11. Network node (107, 108, 109, 110, 111, 112, 113, 114, 207, 208, 209, 210, 211, 212, 213, 214, 307, 308, 309, 310, 311, 312, 313, 314, 407) according to any one of claims 3 to 10, wherein the emitting antenna comprises an antenna with a predefined directivity.

12. Wireless communication network (100, 200, 300) comprising
at least one transmitter (101, 201, 301) according to claim 1,
at least one receiver (115, 215, 315) according to claim 2, and
a plurality of network nodes (107, 108, 109, 110, 111, 112, 113, 114, 207, 208, 209, 210, 211, 212, 213, 214, 307, 308, 309, 310, 311, 312, 313, 314, 407) according to any one of claims 3 to 11.

13. Wireless communication network (100, 200, 300) according to claim 12, wherein the network nodes (107, 108, 109, 110, 111, 112, 113, 114, 207, 208, 209, 210, 211, 212, 213, 214, 307, 308, 309, 310, 311, 312, 313, 314, 407) are arranged in first network node groups (221, 321) and one first network node group (221, 321) is provided for every hop in a signal path from the at least one transmitter (101, 201, 301) to the at least one receiver (115, 215, 315).

14. Wireless communication network (100, 200, 300) according to any one of claims 12 and 13, wherein the network nodes (107, 108, 109, 110, 111, 112, 113, 114, 207, 208, 209, 210, 211, 212, 213, 214, 307, 308, 309, 310, 311, 312, 313, 314, 407) are arranged in second network node groups (222, 322) and one second network node group (222, 322) is provided for every hop in a signal path from the at least one receiver (115, 215, 315) to the at least one transmitter (101, 201, 301).
